(19) Europäisches Patentamt
European Patent Office
Office européen des brevets

(11) **EP 2 116 814 B1**

(12) **EUROPÄISCHE PATENTSCHRIFT**

(45) Veröffentlichungstag und Bekanntmachung des Hinweises auf die Patenterteilung:
**25.06.2014 Patentblatt 2014/26**

(21) Anmeldenummer: **08008768.7**

(22) Anmeldetag: **09.05.2008**

(51) Int Cl.:
*G01D 5/247* *(2006.01)*     *G01D 5/249* *(2006.01)*
*H03M 1/28* *(2006.01)*

(54) **Messeinrichtung zur Ermittlung einer Lage und/oder einer Geschwindigkeit**

Measuring device for calculating a position and/or a speed

Dispositif de mesure destiné à la détermination d'une position et/ou d'une vitesse

(84) Benannte Vertragsstaaten:
**DE**

(43) Veröffentlichungstag der Anmeldung:
**11.11.2009 Patentblatt 2009/46**

(73) Patentinhaber: **Siemens Aktiengesellschaft
80333 München (DE)**

(72) Erfinder: **Finkler, Roland, Dr.
91058 Erlangen (DE)**

(56) Entgegenhaltungen:
**EP-A- 0 268 558      EP-A1- 1 164 358
WO-A-93/25865      US-A- 5 206 586
US-A- 5 317 614      US-B1- 6 178 821
US-B1- 6 556 153**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 116 814 B1

Printed by Jouve, 75001 PARIS (FR)

**Beschreibung**

Die Erfindung betrifft eine Messeinrichtung zur Ermittlung einer Lage und/oder einer Geschwindigkeit.

Aus dem Stand der Technik sind so genannte maßstabsbasierte Messsysteme bekannt. So ist z.B. ein Inkrementalmesssystem aus der DE 27 29 697 A1 bekannt. Maßstabsbasierte Messsysteme in Form von Absolutmesssystemen mit einer PRBS-Spur und mit oder ohne zusätzliche Inkrementalspur sind aus der EP 0 116 636 B1 und der EP 0 530 176 B1 bekannt.

Weiterhin sind auch maßstabsbasierte Messsysteme in Form von Absolutmesssystemen mit parallelen Code-Spuren aus der US 4 654 636 A1 und Messsysteme mit Nonius-Spuren aus der WO 89/11080 bekannt.

Weiterhin sind auch so genannte laufzeitmessungsbasierte Messsysteme, wie z.B. magnetostriktive Messsysteme aus dem Faltblatt "Magnetostriktion, Physikalische Grundlagen" der Firma MTS Sensors, welches auf der Internetseite www.mtssensor.de/fileadmin/medien/downloads/ mts messprinzip.pdf offenbart ist, bekannt.

Weiterhin ist aus der EP 1 164 358 A1 ein induktives Längenmesssystem bekannt.

US 5 317 614 offenbart einen programmierbaren elektronischen Winkelanzeiger, basierend auf technischen Elementen um eine Winkelabweichung eines rotierenden Motors abzuschätzen.

EP 0 268 558 A2 offenbart eine Längen- oder Winkelmesseinrichtung mit einer Maßverkörperung mit einer in gleichen Teilungseinheiten unterteilten ersten Inkrementalteilung.

US 6 556 153 B1 beschreibt ein System und ein Verfahren zur Erhöhung der Genauigkeit eines Encoders oder einer anderen Vorrichtung zur Bestimmung einer Position.

WO 93/25865 beschreibt ein Positionsermittlungssystem für einen bewegten Körper.

US 5 206 586 beschreibt einen linearen magnetostriktiven Positionsgeber, welcher elektrische Impulse anhand der Position eines Magnetes ausgibt.

EP 1 164 358 A1 beschreibt ein induktives Längenmesssystem, das durch die Abtastung von einem Maßstab mit einer Teilung von periodisch variabler Reluktanz und einem Spulensystem in einer linearen Anordnung Informationen betreffend die Position bzw. die Bewegung des Spulensystems bezüglich des Maßstabs erfassen kann.

US 6 178 821 B1 beschreibt einen Sensor für Vibrationen, welcher einen Streifen mit Markierungen nutzt.

Maßstabsbasierte Messsysteme weisen eine so genannte Maßverkörperung auf, die z.B. bei einer linearen Maßverkörperung aus einem Stab besteht, an dem aufeinanderfolgend in Abständen Markierungen angebracht sind. Die Genauigkeit der vom Messsystem ermittelten Lage und/oder Geschwindigkeit hängt dabei unmittelbar von der Präzision ab, mit der die Markierungen an den dafür vorgesehenen Stellen an dem Stab angeordnet werden können. Insbesondere bei großen Maßverkörperungen ist das hochgenaue Anordnen der Markierungen auf dem Messstab oder im Falle von Messsystemen zur Messung einer rotatorischen Bewegung, auf einer entsprechenden Scheibe zur Herstellung der Maßverkörperung sehr aufwendig und kostenintensiv.

Es ist Aufgabe der Erfindung, eine Messeinrichtung zur Ermittlung einer Lage und/oder einer Geschwindigkeit zu schaffen, die eine hohe Genauigkeit der Ermittelung einer Lage und/oder einer Geschwindigkeit eines bewegbaren Elements ermöglicht.

Solchermaßen wird im Umkehrschluss eine Messeinrichtung ermöglicht, die bei einer vorgegebenen zu erzielenden Genauigkeit mit gegenüber dem Stand der Technik ungenauer angeordneten Markierungen auskommt.

Die Aufgabe wird gelöst durch eine Messeinrichtung zur Ermittlung einer Lage und/oder einer Geschwindigkeit, wobei die Messeinrichtung eine Maßverkörperung aufweist, wobei die Maßverkörperung Markierungen aufweist, die mit Abständen zueinander angeordnet sind, wobei die Messeinrichtung einen Abtastkopf aufweist, wobei die Maßverkörperung und der Abtastkopf längs einer Bewegungsrichtung zueinander bewegbar angeordnet sind, wobei der Abtastkopf derart ausgebildet ist, dass mittels des Abtastkopfs, ein erster Abstand des Abtastkopfs in Bewegungsrichtung zu einer ersten Markierung und ein zweiter Abstand des Abtastkopfs in Bewegungsrichtung zu einer zweiten Markierung ermittelbar ist, wobei die Messeinrichtung mittels des ersten und des zweiten Abstands die Lage und/oder die Geschwindigkeit ermittelt.

Vorteilhafte Ausbildungen der Erfindung ergeben sich aus den abhängigen Ansprüchen.

Es erweist sich als vorteilhaft, wenn die erste und die zweite Markierung aufeinanderfolgend angeordnet sind. Hierdurch kann die Abmessung des Abtastkopfs in Bewegungsrichtung klein gehalten werden.

Es erweist sich als vorteilhaft, wenn aufeinanderfolgende Markierungen mit unterschiedlichen Abständen zueinander angeordnet sind, wobei jeder Abstand zwischen zwei aufeinanderfolgenden Markierungen nur einmalig vorhanden ist. Hierdurch wird es dem Abtastkopf ermöglicht, seine absolute Lage auf der Maßverkörperung zu ermitteln. Die Markierungen bilden dabei bei dieser Anordnung der Markierungen eine sogenannte Absolutspur.

Ferner erweist es sich als vorteilhaft, wenn die Markierungen äquidistant beabstandet angeordnet sind. Wenn die Markierungen mit äquidistanten Abständen auf dem Stab angeordnet sind, können die Markierungen besonders einfach auf den Stab aufgebracht werden. Die Markierungen bilden dabei bei dieser Anordnung der Markierungen eine sogenannte Inkrementalspur.

Weiterhin erweist es sich als vorteilhaft, wenn der Abtastkopf zur Ermittelung des ersten und des zweiten Abstands ein Messsystem aufweist, wobei die Markierungen als Magnete oder als magnetisierbare Bauteile ausgebildet sind, wobei das Messsystem eine Sensoreinrichtung und einen Messstab aufweist, wobei der Messstab eine Länge aufweist, die mindestens so groß ist wie der Abstand zwischen drei aufeinanderfolgender Markierungen, wobei die Sensoreinrichtung einen elektrischen Impuls erzeugt, der den Messstab durchläuft und an mindestens zwei aufeinanderfolgenden Markierungen jeweils eine Körperschallwelle erzeugt, wobei die Sensoreinrichtung das zeitliche Eintreffen der beiden Körperschallwellen registriert. Durch die Kombination eines laufzeitmessungsbasierten Messsystems mit einem maßstabbasierten Messsystem lässt sich eine besonders einfache technische Realisierung erzielen.

Weiterhin erweist es sich als vorteilhaft, wenn der Abtastkopf zur Ermittelung des ersten Abstands und des zweiten Abstands mindestens zwei Messsysteme aufweist, wobei die Markierungen als Magnete oder als magnetisierbare Bauteile ausgebildet sind, wobei die Messsysteme jeweilig eine Sensoreinrichtung und jeweilig einen Messstab aufweisen, wobei die Sensoreinrichtung einen elektrischen Impuls erzeugt, der den Messstab durchläuft und an einer Markierung eine Körperschallwelle erzeugt, wobei die Sensoreinrichtung das zeitliche Eintreffen der Körperschallwelle registriert. Durch die Kombination eines laufzeitmessungsbasierten Messsystems mit einem maßstabbasierten Messsystem lässt sich eine besonders einfache technische Realisierung erzielen.

Ferner erweist es sich als vorteilhaft, wenn das Messsystem oder die Messsysteme einen Magneten aufweisen, der ein einzelnes oder mehrere magnetisierbare Bauteile, die in unmittelbarer Nähe des Magneten lokalisiert sind, magnetisiert. Hierdurch kann die Anzahl der benötigten Magnete stark reduziert werden. Weiterhin braucht die Maßverkörperung keine Magnete mehr aufweisen.

Ferner erweist es sich als vorteilhaft, wenn die Markierungen in Form von reflektierenden Markierungen ausgebildet sind, wobei der Abtastkopf mindestens drei Messsysteme aufweist, wobei die Messsysteme jeweilig eine Lichtquelle zur Erzeugung von Licht, einen Codemaßstab, der entsprechend einer Codierung lichtdurchlässige und lichtundurchlässige Stellen aufweist und einen Detektor aufweisen, wobei die Lichtquelle, der Codemaßstab und der Detektor derart angeordnet sind, dass entsprechend der Codierung ein Lichtverteilungsmuster auf die Maßverkörperung projiziert wird und ein von einer Markierung reflektierter Teil des Lichtverteilungsmusters im Detektor detektiert wird. Ein solches Messsystem weist den Vorteil auf, dass es mit hoher Präzision die Lage der Markierungen erfassen kann.

Ferner erweist es sich als vorteilhaft, wenn die Codierung als Gray-Codierung ausgebildet ist. Bei einer Gray-Codierung unterscheiden sich benachbarte Code-Wörter nur um 1 Bit, so dass im Übergangsbereich zwischen den beiden Code-Wörtern immer eines der beiden angrenzenden Code-Wörter gelesen wird. Hierdurch wird eine besonders zuverlässige Ermittelung der Lage und/oder der Geschwindigkeit ermöglicht.

Weiterhin erweist es sich als vorteilhaft, wenn die Messeinrichtung derart ausgebildet ist, dass die Messeinrichtung aus der vorletzt ermittelten Lage, mittels des zur der vorletzt ermittelten Lage zugehörigem ermittelten ersten Abstands und/oder zweiten Abstands und mittels des zu der zuletzt ermittelten Lage zugehörigen ermittelten ersten Abstands und/oder zweiten Abstands, eine zu erwartende Lage bestimmt und bei Nichtübereinstimmung von zuletzt ermittelter Lage und zu erwartender Lage auf eine fehlerhaft ermittelte Lage und/oder Geschwindigkeit erkennt. Hierdurch wird die zuverlässige Erkennung einer fehlerhaft ermittelten Lage und/oder Geschwindigkeit, die z.B. von einem Fehler der Messeinrichtung herrührt, ermöglicht.

Mehrere Ausführungsbeispiele der Erfindung sind in der Zeichnung dargestellt und werden im Folgenden näher erläutert. Dabei zeigen:

FIG 1     eine schematisierte Darstellung des Prinzips der Erfindung,
FIG 2     ein erstes Ausführungsbeispiel der Erfindung
FIG 3     eine weitere Ausführung des Abtastkopfes,
FIG 4     ein zweites Ausführungsbeispiel der Erfindung mit einem auf einer Lichtabtastung basierenden Messsystem,
FIG 5     ein Lichtverteilungsmuster, welches entsprechend eines Codemaßstabs erzeugt wurde und
FIG 6     eine Ausbildung der Erfindung mit einem Abtastkopf, der drei Messsysteme aufweist.

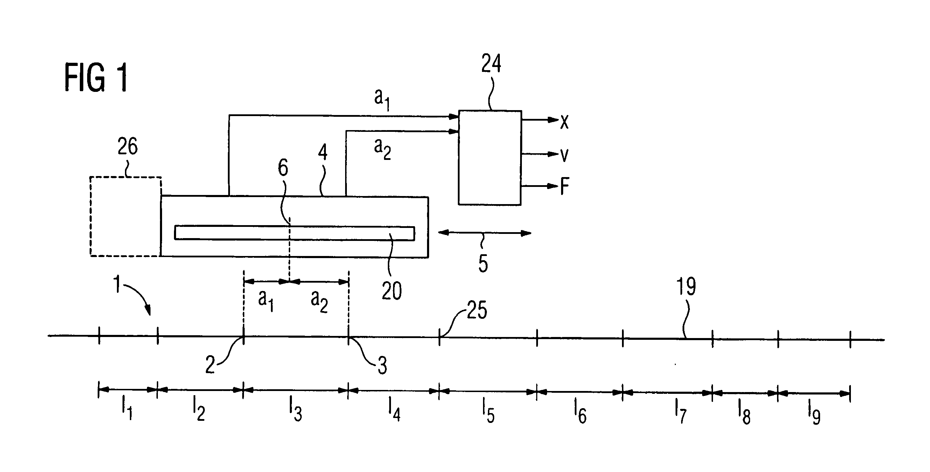

In FIG 1 ist in Form einer schematisierten Darstellung das Funktionsprinzip der Erfindung dargestellt. An einem Stab 19 sind Markierungen mit unterschiedlichen Abständen zueinander angebracht, wobei der Übersichtlichkeit halber nur eine erste Markierung 2, eine zweite Markierung 3 und eine dritte Markierung 25 mit Bezugszeichen versehen sind. Die erste Markierung 2 und die zweite Markierung 3 folgen dabei aufeinander. Genauer ausgedrückt sind die erste Markierung 2 und die zweite Markierung 3 unmittelbar aufeinanderfolgend angeordnet.

Die einzelnen Markierungen weisen dabei zueinander alle unterschiedliche Abstände $l_1$ bis $l_9$ auf. Der Stab 19 bildet zusammen mit den an ihm angebrachten Markierungen eine Maßverkörperung 1. Im Rahmen des Ausführungsbeispiels ist die Maßverkörperung 1 als sogenannte lineare Maßverkörperung ausgebildet, wobei jedoch die Maßverkörperung 1 auch als rotatorische Maßverkörperung ausgebildet sein kann. Bei einer rotatorischen Maßverkörperung wäre der Stab 19 durch eine entsprechende kreisförmige Scheibe ersetzt, an deren Randbereichen die Markierungen entsprechend zueinander beabstandet angebracht sind. Bei der in FIG 1 dargestellten Maßverkörperung ist jeder Abstand $l_1$ bis $l_9$ ($l_i$, mit i =1...9) nur einmalig vorhanden, d.h. alle Abstände $l_1$ bis $l_9$ weisen eine unterschiedliche Größe auf.

Neben der Maßverkörperung 1 weist die erfindungsgemäße Messeinrichtung einen Abtastkopf 4 auf. Der Abtastkopf 4 bewegt sich dabei längs einer Bewegungsrichtung 5, die parallel zum Stab 19 verläuft, entlang. Der Abtastkopf 4 ist dabei im Rahmen des Ausführungsbeispiels an das bewegbare Element 26 dessen Lage x und/oder Geschwindigkeit v mittels der erfindungsgemäßen Messeinrichtung ermittelt werden sollen, angekoppelt, wobei in FIG 1 das bewegbare Element 26 schematisiert gestrichelt gezeichnet andeutet ist. Das bewegbare Element 26 kann z.B. in Form eines Werkstückschlittens einer Werkzeugmaschine vorliegen, an der der Abtastkopf angebracht ist, während die Maßverkörperung 1 ortsfest, z.B. an das Maschinenbett der Werkzeugmaschine, angebracht ist. Selbstverständlich ist es aber auch möglich, dass der Abtastkopf 4 ortsfest angebracht ist, während sich die Maßverkörperung 1 mit dem bewegbaren Element mitbewegt. Die Bewegungsrichtung 5 muss dabei nicht unbedingt, wie in FIG 1 dargestellt, linear sein, sondern kann auch z.B. im Falle einer rotatorischen Maßverkörperung (Scheibe auf die Markieren angebracht sind), falls sich das bewegbare Element rotatorisch bewegt, kreisförmig verlaufen, wobei die Maßverkörperung dann, z.B. an eine Motorwelle, deren Drehlage und Drehgeschwindigkeit mittels der erfindungemäßen Messeinrichtung ermittelt werden sollen, angekoppelt ist. Die Drehgeschwindigkeit kann dabei auch in Form einer Drehfrequenz vorliegen. Die zu ermittelte Lage und/oder die Geschwindigkeit kann somit auch in Form einer Drehlage und/oder Drehgeschwindigkeit vorliegen.

Erfindungsgemäß wird mittels des Abtastkopfes 4, vorzugsweise in Bezug auf eine Referenzstelle 6 des Abtastkopfes, ein erster Abstand $a_1$ des Abtastkopfs 4 in Bewegungsrichtung 5 zu einer ersten Markierung 2 und ein zweiter Abstand $a_2$ des Abtastkopfes 4 in Bewegungsrichtung 5 zu einer zweiten Markierung 3 ermittelt. Die erste Markierung 2 und die zweite Markierung 3 sind dabei aufeinanderfolgend auf dem Stab 19 angeordnet. Die Position der Referenzstelle 6 des Abtastkopfes ist beliebig festlegbar. Vorzugsweise erfolgt die Ermittelung des ersten Abstands a1 und des zweiter Abstand $a_2$ in einem festen Zeitraster. Der Abtastkopf 4 erfasst dabei gleichzeitig die erste Markierung 2 und die zweite Markierung 3, wobei der Abtastkopfs 4 zur Ermittelung des ersten und des zweiten Abstands mindestens ein Messsystem 20 aufweist.

Aus der Summe $a_1 + a_2$ des ersten Abstands $a_1$ und des zweiten Abstands $a_2$ lässt sich aufgrund der unterschiedlichen Abstände $l_1$ bis $l_9$ zunächst ermitteln, zwischen welchen Markierungen sich der Abtastkopf 4 gerade befindet. Im abgebildeten Beispiel gemäß FIG 1 lässt sich anhand der Beziehung $l_3 = a_1 + a_2$ ermitteln, dass sich der Abtastkopf 4 gerade zwischen der ersten Markierung 2 und der zweiten Markierung 3 befindet, da diese eben genau den Abstand $l_3$ voneinander aufweisen und ansonsten keine Abstände zwischen zwei aufeinanderfolgenden Markierungen existieren, die den Abstand $l_3$ voneinander aufweisen.

Eine Auswertung des ersten Abstandes $a_1$ und des zweiten Abstandes $a_2$ liefert dann die Bestimmung der genauen Lage x des Abtastkopfes 4, d.h. genauer ausgedrückt der Referenzstelle 6 innerhalb des Abstands $l_3$. Da die Lagen der ersten Markierung 2 und der zweiten Markierung 3 bekannt sind, kann z.B. durch Addition von $a_1$ zur bekannten Lage der ersten Markierung 2 die Lage der Referenzstelle 6 ermittelt werden. Weiterhin kann die Referenzstelle aber auch ermittelt werden durch Subtraktion des zweiten Abstands $a_2$ von der bekannten Lage der zweiten Markierung 3. Es stehen also immer zur Bestimmung der aktuellen Lage des Abtastkopfs und damit zur Lage des bewegbaren Elements gleichzeitig zwei Lagewerte zur Verfügung. Sind nun die erste Markierung 2 und die zweite Markierung 3 mit einer gewissen Ungenauigkeit an dem Stab 19 angebracht, z.B. geringfügig nach links oder rechts verschoben, so können die beiden solchermaßen gefundenen Lagewerte durch z.B. Mittelung verbessert werden, d.h. die Lage des bewegbaren Elements, ergibt sich durch Bildung des mathematischen Mittelwerts zwischen dem Lagewert, der sich aus Addition des ersten Abstand a1 zur bekannten Lage der ersten Markierung 2 und dem Lagewert, der sich aus der Subtraktion des zweiten Abstand $a_2$ von der bekannten Lage der zweiten Markierung 3 ergibt.

Besonders genau kann mittels der Erfindung die Geschwindigkeit des bewegbaren Elements ermittelt werden, da die Genauigkeit der Lagedifferenz $x_2 - x_1$ zwischen zwei aufeinanderfolgend ermittelten Lagen $x_1$ und $x_2$, die zur Ermittelung der Geschwindigkeit $v = (x_2 - x_1)/\Delta t$ ($\Delta t$: Zeitdifferenz zwischen dem Durchlaufen der beiden Lagen) notwendig ist, lediglich durch die Messungenauigkeit des ermittelten ersten Abstandes $a_1$ und des ermittelten zweiten Abstandes $a_2$ abhängt. Die Lage der ersten Markierung 2 und der zweiten Markierung 3 spielen bei der Ermittlung der Geschwindigkeit des bewegbaren Elements somit keine Rolle mehr (sie kürzen sich mathematisch bei der Berechnung der Geschwindigkeit v heraus), d.h. sie werden zur Ermittelung der Geschwindigkeit nicht benötigt und in Folge wirken sich ungenau angebrachte Markierungen auf dem Stab 19 und damit eine ungenaue Maßverkörperung nicht negativ auf die Genauigkeit der ermittelten Geschwindigkeit aus. Dies gilt auch dann, wenn der Abtastkopf 4 zwischen zwei aufeinanderfolgenden Erfassungszeitpunkten der Abstände von einem Bereich zwischen zwei bestimmten Markierungen in den benachbarten Bereich wechselt.

Insbesondere bei der Ermittlung der Geschwindigkeit hängt somit bei der erfindungsgemäßen Messeinrichtung die Genauigkeit der ermittelten Geschwindigkeit nur noch davon ab, wie genau der erste und der zweite Abstand in Bezug auf eine Referenzstelle 6 des Abtastkopfes ermittelt werden können aber nicht mehr von der Genauigkeit mit der die Markierungen an dem Stab 19 angeordnet sind.

Zur oben beschrieben Ermittelung der Lage x und/oder Geschwindigkeit v des bewegbaren Elements weist die Messeinrichtung eine Auswerteeinheit 24 auf, die die beiden Abstände $a_1$ und $a_2$ einliest und daraus wie oben beschrieben die Lage x und/oder Geschwindigkeit v ermittelt und ausgibt. Die Auswerteeinheit 24 kann wie in FIG 1 außerhalb des Abtastkopfs 4 realisiert sein oder aber auch Bestandteil des Abtastkopfs 4 sein.

Im Rahmen des Ausführungsbeispiels gemäß FIG 1 wird die Lage x der Referenzstelle 6 des Abtastkopfes 4 durch Ermittlung der Abstände $a_1$ und $a_2$ zwischen zwei aufeinanderfolgenden Markierungen ermittelt. Wenn die Genauigkeit der Lage x und/oder Geschwindigkeit v weiter verbessert werden soll, können auch noch zusätzlich die Abstände der Referenzstelle 6 zu einer vorzugsweise hintereinander angeordneten dritten Markierung 25 oder noch weiteren vorzugsweise hintereinander angeordneten Markierungen ermittelt werden. Der Abtastkopf 4 muss hierzu in diesem Fall so ausgebildet sein, dass dieser, z.B. wenn der Abstand von Referenzstelle 6 zur dritten Markierung 25 für die Auswertung ermittelt werden soll, dass dieser die dritte Markierung 25 neben der ersten Markierung 2 und der zweiten Markierung 3 simultan erfassen kann. Zur Ermittlung des ersten Abstands $a_1$ und des zweiten Abstands $a_2$ weist der Abtastkopf 4 mindestens ein Messsystem 20 auf.

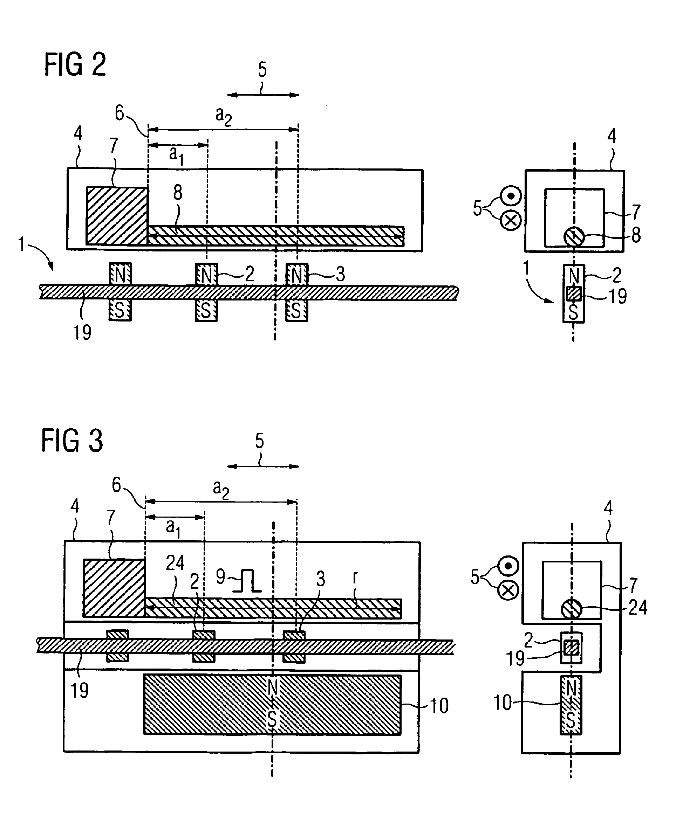

In FIG 2 ist schematisiert eine erste Ausbildung des Messsystems 20 zur Ermittlung des ersten Abstandes $a_1$ und des zweiten Abstandes $a_2$ dargestellt. Das Messsystem ist dabei als magnetostriktives Messsystem realisiert. Das Messsystem weist eine Sensoreinrichtung 7 und eine an der Sensoreinrichtung angeordneten Messstab 8 auf. Die Sensoreinrichtung 7 erzeugt in einem festen Taktraster elektrische Impulse 9, die den Messstab 8 in Form von Stromimpulsen durchlaufen. Die Maßverkörperung 1 wird durch einen Stab 19 gebildet, an dem entsprechend FIG 1 Markierungen zueinander beabstandet angebracht sind. Die Markierungen sind bei der Ausführungsform gemäß FIG 2 als Magnete, insbesondere Permanentmagnete ausgebildet. Dargestellt sind in FIG 2 die erste Markierung 2 und die zweite Markierung 3, die den Abstand $l_3$ zueinander aufweisen. Weiterhin ist links von der Markierung 2 eine weitere Markierung dargestellt. Der Übersichtlichkeit halber ist rechts von der Markierung 3 keine weitere Markierung mehr dargestellt. Die drei in FIG 2 dargestellten Markierungen folgen aufeinander. Die Magnete erzeugen an ihrer jeweiligen Position ein Magnetfeld, welches an der jeweiligen Position den Messstab 8 lokal erfasst. An der Position der ersten Markierung 2 und der zweiten Markierung 3 erzeugt das vom elektrischen Impuls 9 mitgeführte magnetische Feld eine mechanische Torsion, die innerhalb des Messstabs 8 eine sogenannte Körperschallwelle erzeugt, die zur Sensoreinrichtung 7 zurückläuft. Unter Vernachlässigung der zeitlichen Dauer, die der elektrische Impuls benötigt, um die erste Markierung 2 und die zweite Markierung 3 zu erreichen, ergibt sich der erste Abstand $a_1$ zu

$$a1 = G \cdot \Delta t_1$$

und der zweite Abstand $a_2$ zu

$$a2 = G \cdot \Delta t_2,$$

G: Geschwindigkeit der Körperschallwelle

d.h. aus den Zeitdauern $\cdot \Delta t_1$ und $\Delta t_2$, die die Körperschallwelle jeweilig benötigt, um von der Position des jeweiligen Permanentmagneten zur Sensoreinrichtung 7 zurückzulaufen, lassen sich der erste Abstand a1 und der zweite Abstand a2 berechnen. Die jeweiligen Zeitdauern $\cdot \Delta t_1$ und $\cdot \Delta t_2$ sind dabei die Zeitdauern zwischen Erzeugung des jeweiligen Impulses und Registrierung des jeweiligen Impulses in der Sensoreinrichtung 7, wobei die Referenzstelle 6 vorzugsweise auf die Position des Eingangs der Sensoreinrichtung 7 gelegt wird. Jeder elektrische Impuls erzeugt solchermaßen zwei Körperschallwellen mit Hilfe derer der erste Abstand $a_1$ und der zweite Abstand $a_2$ in Bezug zu einer Referenzstelle 6 ermittelt werden. In FIG 2 rechtseitig ist ein Schnitt durch den erfindungsgemäßen Abtastkopf und die Maßverkörperung 1 dargestellt. Der Abtastkopf bewegt sich in Richtung der Bewegungsrichtung 5.

Bei der erfindungsgemäßen Messeinrichtung wird somit zur Realisierung ein maßstabbasiertes Messsystem mit einem laufzeitbasierten Messsystem, wie z.B. einem magnetostriktiven Messsystem, in vorteilhafter Weise kombiniert.

Damit die Sensoreinrichtung 7 auch mit einem elektrischen Impuls sowohl den ersten Abstand $a_1$ als auch den zweiten Abstand $a_2$ messen kann, muss der Messstab 8 eine Länge r aufweisen, die mindestens so groß ist, wie der Abstand zwischen drei aufeinanderfolgender Markierungen, wobei falls die Abstände zwischen den Markierungen unterschiedliche sind, wie in FIG 1 dargestellt, die Länge r des Messstabs 8 mindestens so groß sein muss, wie der größte Abstand zwischen drei aufeinanderfolgender Markierungen. Dadurch wird sichergestellt, dass der Messstab in jeder Position des Abtastkopfs 4 mindestens zwei Markierungen überdeckt.

In FIG 3 ist eine weitere Ausbildungsform des magnetostriktiven Messsystems, wie in FIG 2 dargestellt, und im obigen Abschnitt beschrieben, offenbart. Die in FIG 3 dargestellte Ausführungsform entspricht im Grundaufbau im Wesentlichen der vorstehend, in FIG 2 beschriebenen Ausführungsform. Gleiche Elemente sind daher in FIG 3 mit den

gleichen Bezugzeichen versehen wie in FIG 2. Der wesentliche Unterschied besteht darin, dass bei der Ausführungsform gemäß FIG 3 die Markierungen nicht in Form von Magneten ausgebildet sind, sondern in Form von magnetisierbaren Bauteilen ($\mu_{rel} > 1$), wie z.B. einem unmagnetisierten Eisenstück. Im Rahmen des Ausführungsbeispiels gemäß FIG 3 weist dabei der Abtastkopf 4 einen Magneten 10 auf, der vorzugsweise als Permanentmagnet ausgebildet ist. Beim Vorbeigleiten des Abtastkopfes über die magnetisierbaren Bauteile, die die Markierungen bilden, werden die gerade in unmittelbarer Nähe des Magneten 10 lokalisierten magnetisierbaren Bauteile temporär magnetisiert, so dass temporär wieder die schon in FIG 2 dargestellten Magnete als Markierungen entstehen. In FIG 3 sind die diesmal als magnetisierbare Bauteile ausgebildete erste Markierung 2 und die zweite Markierung 3, sowie eine links von der Markierung angeordnete weitere Markierung dargestellt. Die magnetisierbaren Bauteile dienen solchermaßen quasi als magnetisch leitende Elemente, die das Magnetfeld des Magneten 10 gezielt an den Positionen der Markierungen in den Messstab 8 einleiten.

In FIG 2 und FIG 3 ist rechtsseitig die jeweilig zugehörige Schnittansicht dargestellt.

Anstatt des einzelnen oben beschrieben magnetostriktiven Messsystems kann der Abtastkopf 4 auch mehrere magnetostriktive Messsysteme aufweisen, wobei z.B. ein erstes magnetostriktives Messsystem zur Ermittelung des ersten Abstands $a_1$ und eine zweites magnetostriktives Messsystem zur Ermittelung des zweiten Abstands $a_2$ verwendet wird, wobei in diesem Fall der jeweilige Messstab 8 der magnetostriktiven Messsystem nicht mehr eine Länge aufweisen muss, die mindestens so groß ist, wie der Abstand zwischen drei aufeinanderfolgender Markierungen.

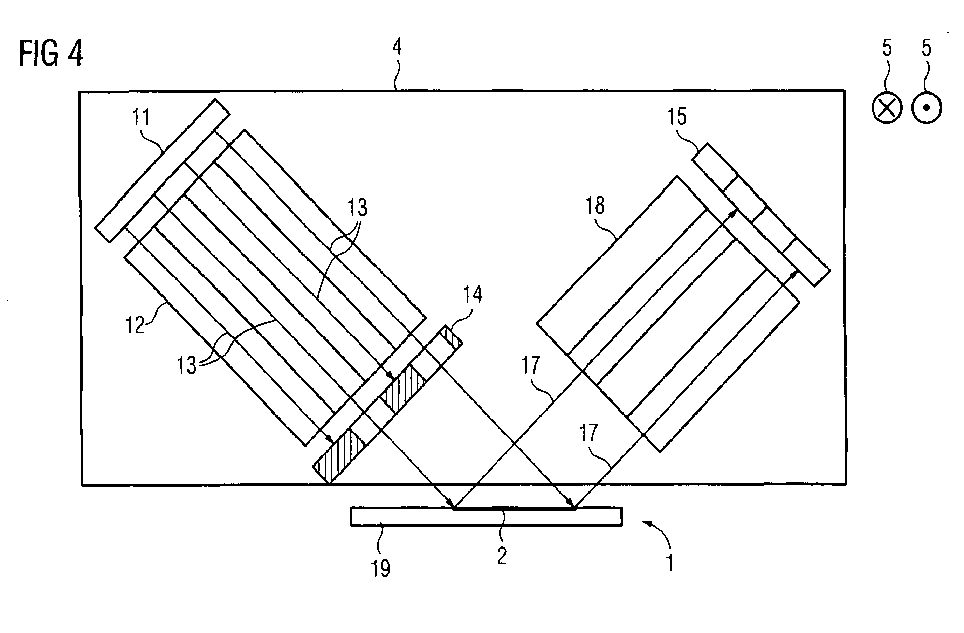

In FIG 4 ist eine weitere Ausbildung des Abtastkopfes 4 im Rahmen einer schematisierten Schnittdarstellung dargestellt. Das Messsystem ist im Rahmen dieser Ausbildung als lichtbasiertes Messsystem ausgebildet. Der Abtastkopf bewegt sich im Rahmen des Ausführungsbeispiels gemäß FIG 4 entlang der Bewegungsrichtung 5, d.h. in der Darstellung gemäß FIG 4 in die Zeichenebene hinein oder aus ihr hinaus. Das Messsystem weist eine Lichtquelle 11, ein erstes Röhrenarray 12, ein zweites Röhrenarray 18, einen Detektor 15, sowie einen Codemaßstab 14 auf.

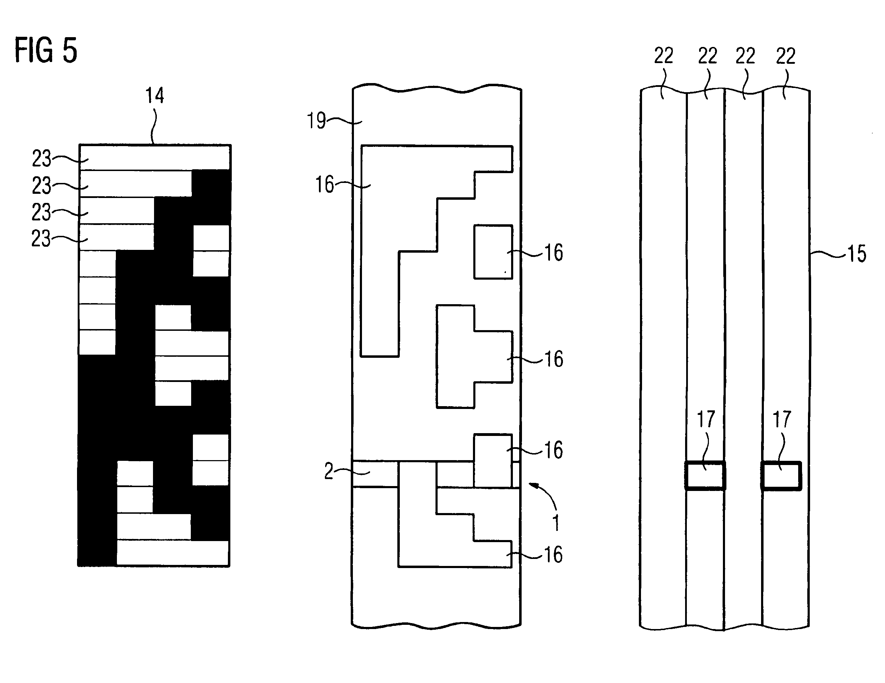

Das von der Lichtquelle 1 erzeugte Licht 13 wird mittels des ersten Röhrenarrays 12 so geführt, das auf den Codemaßstab 14 das Licht 13 nur noch senkrecht zur Bewegungsrichtung auftrifft. Der Codemaßstab 14 ist aus lichtdurchlässigen und lichtundurchlässigen Stellen zusammengesetzt und lässt daher das Licht 13 nur teilweise passieren. In FIG 5 ist linksseitig der Codemaßstab 14 im Rahmen einer Draufsicht dargestellt, wobei die lichtdurchlässigen Stellen weiß und die lichtundurchlässigen Stellen schwarz dargestellt sind. Die Anordnung der lichtdurchlässigen und lichtundurchlässigen Stellen eine Codierung dar. Entsprechend der Codierung des Codemaßstabs 14, d.h. entsprechend der Anordnung der lichtdurchlässigen und lichtundurchlässigen Stellen des Codemaßstabs 14, wird auf die Maßverkörperung 1 ein Lichtverteilungsmuster 16 projiziert, das in der mittleren Abbildung in FIG 5 dargestellt ist. Die Maßverkörperung 1 ist im Rahmen dieses Ausführungsbeispiels als ein flacher Stab 19 ausgebildet, auf den wie zur FIG 1 beschrieben in unterschiedlichen Abständen von einander lichtreflektierende Markierungen in Form von schmalen Streifen angebracht sind. In der mittleren Abbildung in FIG 5 ist eine erste Markierung 2 dargestellt. Der von der ersten Markierung 2 reflektierte Teil des Lichtverteilungsmusters wird anschließend von einem Detektor 15 erfasst. Gegebenenfalls kann vor dem Detektor 15 ein zweites Röhrenarray 18 (siehe FIG 4), das nur paralleles Licht durchlässt, geschaltet sein, um Streulicht auszublenden. Der Detektor 15 ist in der rechten Abbildung in FIG 5 dargestellt, wobei vom Detektor 15 der reflektierte Teil 17 des Lichtverteilungsmusters 16 detektiert wird. Der Detektor 15 ist dabei vorzugsweise aus streifenförmigen Einzeldetektoren 22 aufgebaut, die die einfallende Lichtintensität quasi aufintegrieren. In der linken Abbildung in FIG 5 ist zu erkennen, dass der Codemaßstab 14 horizontale Bereiche 23 aufweist, wobei der Übersichtlichkeit halber nur ein Teil der horizontalen Bereiche mit Bezugsziffern versehen ist. Ein horizontaler Bereich stellt gemäß der verwendeten Codierung des Codemaßstabs ein Code-Wort dar. Durch die reflektierende Markierung 2 wird im dargestellten Fall genau ein einzelnes der Code-Wörter auf den Detektor 15 geleitet und kann dort vom Detektor 15 gelesen werden.

Im Allgemeinen wird sich aber oft eine Mischung aus zwei benachbarten Code-Wörtern ergeben. Aus diesem Grund ist eine sogenannte Gray-Codierung vorteilhaft, bei der sich benachbarte Code-Wörter, um nur 1 Bit unterscheiden, so dass im Übergangsbereich letztlich immer eines der beiden angrenzenden Code-Wörter gelesen wird. Gray-Codierungen sind dabei dem Fachmann allgemein bekannt.

Das oben beschriebene lichtbasierte Messsystem funktioniert in der angegebenen Weise, wenn nur immer der reflektierte Teil des Lichtverteilungsmusters von einer einzelnen Markierung, die sich beim Bewegungsvorgang gerade in unmittelbarer Nähe des Messsystems befindet, vom Detektor 15 detektiert wird. Daher muss jedes der Messsysteme immer kürzer als der kürzeste Abstand zweier aufeinanderfolgender Markierungen sein über denen es sich befinden kann. Daher wiederum sind auch Positionen des Abtastkopfs möglich in denen sich ein Messsystem gerade über keiner Markierung, sondern zwischen zwei aufeinanderfolgenden Markierungen befindet. Daher muss der Abtastkopf mindestens drei der oben beschriebenen lichtbasierten Messsysteme aufweisen, wobei ein Messsystem zur Ermittelung des ersten Abstands $a_1$ dient und ein weiteres Messsystem zur Ermittelung des zweiten Abstands $a_2$ dient.

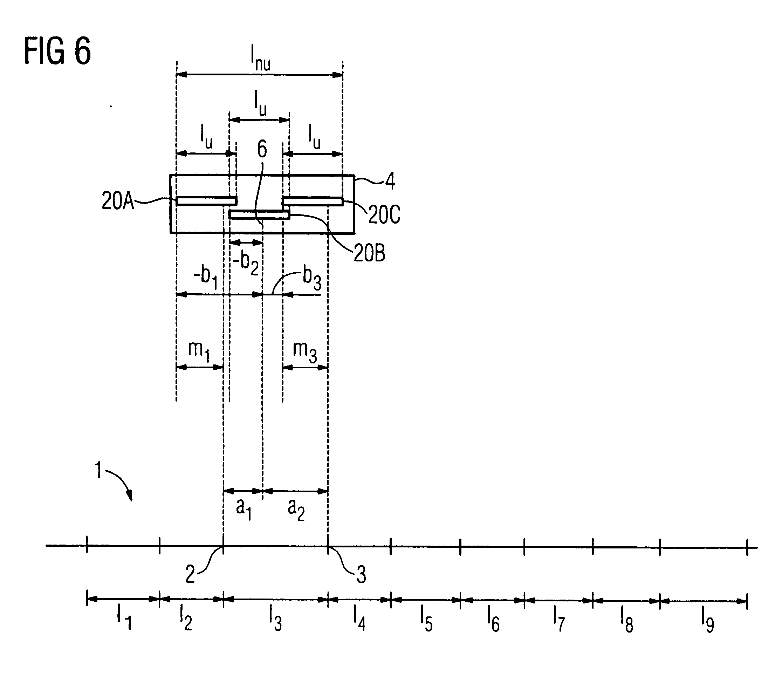

In FIG 6 ist in Form einer schematisierten Darstellung ein Abtastkopf dargestellt, der im Rahmen des Ausführungsbeispiels die drei lichtbasierten Messsysteme 20A, 20B und 20C aufweist, die vorzugsweise gleiche Teillängen $l_u$ der Maßverkörperung 1 erfassen. Die Erfassungsbereiche der Messsysteme 20A, 20B und 20C überlappen sich dabei jeweils zu einem kleinen Teil, so dass sie insgesamt die Länge $l_{nu} < n \cdot l_U$ der Maßverkörperung 1 erfassen, wobei n die Anzahl der Messsysteme ist, also im Rahmen des Ausführungsbeispiels 3 beträgt. Wenn dabei die Bedingung

$$l_u < \min(l_i) < \max(l_i + l_{i+1}) < l_{nu} < n \cdot l_u$$

$l_i$ : Abstände zwischen den Markierungen
erfüllt ist, können an jeder Position des Abtastkopfs 4 mindestens zwei Messsysteme zur Lagebestimmung verwendet werden. Es sein an dieser Stelle angemerkt, dass es sich bei der Abbildung gemäß FIG 6 nur um eine schematisierte Darstellung handelt, so dass bei den dargestellten Abmessungen der einzelnen Elemente in FIG 6 oben genannte Beziehung unter Umständen nicht immer erfüllt ist.

Die Maße -$b_1$, -$b_2$, $b_3$ ($b_1 < 0$, $b_2 < 0$, $b_3 > 0$) können als bekannt vorausgesetzt werden, da sie sich aus der bekannten Geometrie des Abtastkopfes ergeben. Im dargestellten Beispiel wird von den Messsystemen 20A und 20C jeweils eine Markierung erfasst, wobei sich die Messgrößen $m_1$ und $m_3$ ergeben. Der erste Abstand $a_1$ und der zweite Abstand $a_2$ ergeben sich dann aus den Beziehungen

$$a_1 = -b_1 - m_1,$$

$$a_2 = b_3 + m_3 .$$

Für den Fall, dass sich die Markierungen unter anderen zweien der drei Messsystem befinden, lassen sich in naheliegender Weise entsprechende Beziehungen angeben.

Es sei an dieser Stelle angemerkt, dass die Referenzstelle 6, auf die sich die Abstände zu den nächstliegenden Markierungen beziehen an einer beliebigen Position längs des Abtastkopfes 4 gewählt werden kann. Entsprechend der gewählten Position der Referenzstelle 6 am Abtastkopf 4 müssen oben stehenden mathematischen Beziehungen zur Ermittelung des ersten Abstandes $a_1$ und des zweiten Abstandes $a_2$ entsprechend angepasst werden. Im Rahmen des Ausführungsbeispiels gibt der Abtastkopf 4 den ersten Abstand $a_1$ und den zweiten Abstand $a_2$ als Ausgangsgröße aus. Alternativ kann der Abtastkopf aber auch die Messgrößen $m_1$ und $m_3$ ausgeben und die oben stehende Berechnung des ersten Abstands $a_1$ und des zweiten Abstands $a_2$ aus den Messgrößen $m_1$ und $m_3$ wird in der Auswerteeinheit 24 durchgeführt.

Weiterhin sei an dieser Stelle angemerkt, dass selbstverständlich die Maßverkörperung 1 auch so ausgebildet sein kann, dass alle Markierungen den gleichen Abstand zueinander aufweisen. In diesem Fall ist jedoch im Allgemeinen bei Verwendung von gleich beabstandeten Markierungen an einer Stelle der Maßverkörperung ein Referenzpunkt notwendig, mit Hilfe derer die Messeinrichtung in der Lage ist, falls die Ermittlung einer Absolutlage erwünscht ist, sich zu referenzieren. Oft ist jedoch auch nur die Ermittlung einer Geschwindigkeit notwendig, so dass auf unterschiedlich beabstandete Markierungen verzichtet werden kann und die Markierungen somit alle den gleichen Abstand zueinander aufweisen.

Es ist jedoch prinzipiell auch möglich, bei der Erfindung andere bei Messeinrichtungen bekannte Maßverkörperungen zu verwenden, wie z.B. ein Absolutmaßstab mit parallelen Spuren und paralleler Inkrementalspur oder eine sogenannte PRBS-Maßverkörperung mit und ohne zusätzlicher Inkrementalspur. Der reflektierende Teil für die PRBS-Spur erstreckt sich dabei entsprechend der Länge des Messsystems, die handelsüblich verwendet wird, in dem der Maßstab als Teil der Maßverkörperung eingesetzt wird und die Einzeldetektoren für die PRBS-Spur nicht steifenförmig und nicht quer zur Bewegungsrichtung, wie in FIG 5 rechtsseitig dargestellt, sondern in Bewegungsrichtung angeordnet sind. Der Inkrementalspur ist beispielsweise dabei genau ein Einzeldetektor zugeordnet, der sich in Bewegungsrichtung über ein halbes Inkrement erstreckt.

Ferner sei an dieser Stelle angemerkt, dass es auch denkbar ist, das Messsystem mit Hilfe einer optischen Zeilenkamera oder eines nicht-optischen Analogons dazu zu verwenden. Ein solches nicht-optisches Analogon kann z.B. induktiv (z.B. entsprechend dem AMOSIN®-Messprinzip siehe EP1164358 A1) oder magnetisch (z.B. entsprechend dem Zahnradgeber-Prinzip) funktionieren.

Bei der Steuerung und Regelung von Antrieben werden die Lagewerte meist in einem festen Zeitraster (z.B. alle 125 μsec.) von der Messeinrichtung ausgegeben. Oft werden dabei auch an die Messeinrichtung erhöhte Sicherheitsanforderungen gestellt, in dem Sinne, das von der Messeinrichtung zwei voneinander unabhängig ermittelte Lagewerte gefordert werden, die anschließend, z.B. auf Übereinstimmung, überprüft werden. Diese Anforderung kann mit der erfindungsgemäßen Messeinrichtung auf folgende Weise erfüllt werden, wobei die Auswertung im Rahmen des Ausführungsbeispiels in der Auswerteeinheit 24 gemäß FIG 1 durchgeführt wird.

Zunächst wird aus der vorletzt ermittelten Lage $x_1$ (vorletzt ermittelter Lagewert) eine zu erwartende Lage $x_2^*$ gemäß der Beziehung

$$x_2{}^* \;=\; x_1 \;+\; a_1 \;-\; a_1{}'$$

wobei $a_1'$ der zur Ermittelung der vorletzt ermittelten Lage $x_1$ gemessener erster Abstand ist und $a_1$ der zur Ermittelung der zuletzt ermittelten Lage $x_2$ (zuletzt d.h. der aktuell ermittelter Lagewert) gemessener erster Abstand ist.

Die zu erwartende Lage $x_2^*$ wird anschließend mit der zuletzt ermittelten Lage $x_2$ verglichen und bei Nichtübereinstimmung d.h. (Betrag($x_2 - x_2^*$) > voreingestellter Grenzwert) wird auf eine fehlerhaft ermittelte Lage erkannt und von der Auswerteeinheit 24 ein Fehlersignal F ausgegeben.

Anstelle der Verwendung der ersten Abstände $a_1'$ und $a_1$ kann auch in analoger Weise (siehe Beziehung unten) die zu erwartende Lage $x_2^*$ aus den entsprechenden zweiten Abständen $a_2'$ und $a_2$ bestimmt werden, wobei $a_2'$ der zur Ermittelung der vorletzt ermittelten Lage $x_1$ gemessene zweite Abstand ist und $a_2$ der zur Ermittelung der zuletzt ermittelten Lage $x_2$ (zuletzt d.h. der aktuell ermittelter Lagewert) gemessene zweite Abstand ist.

$$x_2{}^* \;=\; x_1 \;+\; a_2{}' \;-\; a_2$$

Entsprechend sind aber auch komplexere Verfahren zur Bestimmung der zu erwartenden Lage $x_2^*$ denkbar, die z.B. unter Verwendung sämtlicher oder einen Teils der Größen $x_1$, $a_1'$, $a_1$, $a_2'$, $a_2$, z.B. mittels Mittelwertbildung, die erwartende Lage $x_2^*$ bestimmen.

Weiterhin sei an dieser Stelle angemerkt, dass die Auswerteeinheit 24 auch noch Kompensationsalgorithmen zum Ausgleich von Ungenauigkeiten im Abtastkopf und/oder auf der Maßverkörperung enthalten kann. Die Parameter für die Kompensationsalgorithmen können z.B. vorab mit Hilfe einer temporär angeordneten besonders genauen Maßverkörperung und/oder während des Betriebs (z.B. genaue Bestimmung der Werte von $l_i$ anhand der jeweilig zugehörigen ermittelten Abstände $a_1$ und $a_2$) ermittelt werden.


## Patentansprüche

1.   Messeinrichtung zur Ermittelung einer Lage (x) und/oder einer Geschwindigkeit (v), wobei die Messeinrichtung eine Maßverkörperung (1) aufweist, wobei die Maßverkörperung (1) Markierungen (2, 3, 25) aufweist, die mit Abständen ($l_1$ - $l_9$) zueinander angeordnet sind, wobei die Messeinrichtung einen Abtastkopf (4) aufweist, wobei die Maßverkörperung (1) und der Abtastkopf (4) längs einer Bewegungsrichtung (5) zueinander bewegbar angeordnet sind, wobei der Abtastkopf (4) derart ausgebildet ist, dass mittels des Abtastkopfs (4), ein erster Abstand ($a_1$) des Abtastkopfs in Bewegungsrichtung (5) zu einer ersten Markierung (2) und ein zweiter Abstand ($a_2$) des Abtastkopfs (4) in Bewegungsrichtung (5) zu einer zweiten Markierung (3) ermittelbar ist, wobei die Messeinrichtung mittels des ersten ($a_1$) und des zweiten Abstands ($a_2$) die Lage (x) und/oder die Geschwindigkeit (v) ermittelt, wobei aufeinanderfolgende Markierungen mit unterschiedlichen Abständen ($l_1$-$l_9$) zueinander angeordnet sind, wobei jeder Abstand ($l_1$-$l_9$) zwischen zwei aufeinanderfolgenden Markierungen nur einmalig vorhanden ist, wobei der Abtastkopf zur Ermittelung des ersten Abstands ($a_1$) und des zweiten Abstands ($a_2$) mindestens zwei Messsysteme (20A, 20B) aufweist, wobei die Markierungen als Magnete (2,3) oder als magnetisierbare Bauteile (2, 3) ausgebildet sind, wobei die Messsysteme jeweilig eine Sensoreinrichtung (7) und jeweilig einen Messstab (8) aufweisen, wobei die Sensoreinrichtung (7) einen elektrischen Impuls (9) erzeugt, der den Messstab (8) durchläuft und an einer Markierung eine Körperschallwelle erzeugt und wobei die Sensoreinrichtung das zeitliche Eintreffen der Körperschallwelle registriert.

2.   Messeinrichtung nach Anspruch 1, wobei die erste (2) und die zweite Markierung (3) aufeinanderfolgend angeordnet sind.

3.   Messeinrichtung nach Anspruch 1 oder 2, wobei das Messsystem (20) oder die Messsysteme einen Magneten (10) aufweisen, der ein einzelnes oder mehrere magnetisierbare Bauteile (2,3), die in unmittelbarer Nähe des Magneten (10) lokalisiert sind, magnetisiert.

4.   Messeinrichtung nach einem der vorhergehenden Ansprüche, wobei die Messeinrichtung derart ausgebildet ist, dass die Messeinrichtung aus der zuvorletzt ermittelten Lage ($x_1$) und aus der zuletzt ermittelten Lage ($x_2$) eine zu erwartende Lage ($x_2$*) bestimmt, wobei die Bestimmung anhand der zu vorletzt ermittelten Lage ($x_1$) zugehörig ermittelten ersten Abstandes ($a_1$') und/oder zweiten Abstandes ($a_2$') sowie anhand der zuletzt ermittelten Lage ($x_x$) zugehörigen ersten Abstandes ($a_1$) und/oder zweiten Abstandes ($a_2$) vorgesehen ist, und bei Nichtübereinstimmung von zuletzt ermittelter Lage ($x_2$) und zu erwartender Lage ($x_2$*) auf eine fehlerhaft ermittelte Lage (x) und/oder Geschwindigkeit (v) erkennt.

## Claims

1. Measuring device for determining a position (x) and/or a speed (v), the measuring device having a scale (1), the scale (1) having marks (2, 3, 25) that are arranged at spacings ($l_1$-$l_9$) from one another, the measuring device having a scanning head (4), the scale (1) and the scanning head (4) being arranged such that they can be moved relative to one another along a movement direction (5), the scanning head (4) being designed in such a way that it is possible to determine by means of the scanning head (4) a first spacing ($a_1$) of the scanning head in the movement direction (5) relative to a first mark (2), and a second spacing ($a_2$) of the scanning head (4) in the movement direction (5) relative to a second mark (3), the measuring device determining the position (x) and/or the speed (v) by means of the first spacing ($a_1$) and the second spacing ($a_2$), successive marks being arranged with different spacings ($l_1$-$l_9$) from one another, each spacing ($l_1$-$l_9$) being present only once between two successive marks, the scanning head having at least two measuring systems (20A, 20B) for determining the first spacing ($a_1$) and the second spacing ($a_2$), the marks being designed as magnets (2, 3) or as magnetizable components (2, 3), the measuring systems respectively having a sensor device (7) and respectively having a measuring rod (8), the sensor device (7) generating an electric pulse (9) that traverses the measuring rod (8) and generates a structure borne sound wave at a mark, and the sensor device recording the temporal arrival of the structure borne sound wave.

2. Measuring device according to Claim 1, with the first mark (2) and the second mark (3) being arranged successively.

3. Measuring device according to Claim 1 or 2, with the measuring system (20) or the measuring systems having a magnet (10) that magnetizes a single or a number of magnetizable components (2, 3) that are located in the immediate vicinity of the magnet (10).

4. Measuring device according to one of the preceding claims, with the measuring device being designed in such a way that the measuring device ascertains a position ($x_2$*) to be expected from the penultimately determined position ($x_1$) and from the last determined position ($x_2$), the ascertainment being provided by means of the determined first spacing ($a_1$') belonging to the penultimately determined position ($x_1$) and/or of the second spacing ($a_2$'), and by means of the first spacing ($a_1$) belonging to the last determined position ($x_2$) and/or of the second spacing ($a_2$), and detects an incorrectly determined position (x) and/or speed (v) upon a disagreement between the last determined position ($x_2$) and the position ($x_2$*) to be expected.

## Revendications

1. Dispositif de mesure pour la détermination d'une position ( x ) et/ou d'une vitesse ( v ), le dispositif de mesure ayant une représentation ( 1 ) d'une valeur, la représentation ( 1 ) d'une valeur ayant des repères ( 2 , 3 , 25 ) qui sont disposés à des distances ( $1_1$ à $1_9$ ) les uns des autres, le dispositif de mesure ayant une tête ( 4 ) d'analyse, la représentation ( 1 ) d'une valeur et la tête ( 4 ) d'analyse étant montées mobiles l'une par rapport à l'autre dans une direction ( 5 ) de déplacement, la tête ( 4 ) d'analyse étant constituée de manière à pouvoir, au moyen de la tête ( 4 ) d'analyse, déterminer une première distance ( $a_1$ ) de la tête d'analyse dans la direction ( 5 ) de déplacement à un premier repère ( 2 ) et une deuxième distance ( $a_2$ ) de la tête ( 4 ) d'analyse dans la direction ( 5 ) de déplacement à un deuxième repère ( 5 ), le dispositif de mesure déterminant la position ( x ) et/ou la vitesse ( v ) au moyen de la première ( $a_1$ ) > et de la deuxième distance ( $a_2$ ),
dans lequel des repères qui se succèdent sont disposés les uns par rapport aux autres à des distances ( $1_1$ à $1_9$ ) différentes, chaque distance ( $1_1$ à $1_9$ ) n'étant présente qu'une seule fois entre deux repères qui se succèdent, la tête d'analyse ayant au moins deux systèmes ( 20A , 20B ) de mesure pour la détermination de la première distance ( $a_1$ ) et de la deuxième distance ( $a_2$ ),
dans lequel les repères sont constitués sous la forme d'aimants ( 2 , 3 ) ou d'éléments ( 2 , 3 ) magnétisables, les systèmes de mesure ayant respectivement un dispositif ( 7 ) formant capteur et respectivement un barreau ( 8 ) de mesure, le dispositif ( 7 ) formant capteur produisant une impulsion ( 9 ) électrique qui passe dans le barreau ( 8 ) de mesure et qui produit sur un repère une onde de bruit de structure et le dispositif formant capteur enregistrant l'arrivée dans le temps des ondes de bruit de structure.

2. Dispositif de mesure suivant la revendication 1, dans lequel le premier ( 2 ) le deuxième repères ( 3 ) sont disposés en se succédant l'un après l'autre.

3. Dispositif de mesure suivant la revendication 1 ou 2, dans lequel le système ( 20 ) de mesure ou les systèmes de mesure ont un aimant ( 10 ) qui magnétise un élément ( 2 ) magnétisable individuel ou plusieurs éléments ( 2 , 3 ) magnétisables qui sont localisés à proximité immédiate de l'aimant ( 10 ).

4. Dispositif de mesure suivant l'une quelconque des revendications précédentes, dans lequel le dispositif de mesure est constitué de manière déterminée, une position ( $x_2*$ ) escomptée à partir de la position ( $x_1$ ) déterminée en avant dernier et de la position ( $x_2$ ) déterminée en dernier, la détermination s'effectuant au moyen de la première distance ($a_1'$) et/ou de la deuxième distance ( $a_2'$ ) déterminées associées à la position ( $x_1$ ) déterminée en avant dernier, ainsi qu'au moyen de la première distance ( $a_1$ ) et/ou de la deuxième distance ( $a_2$ ) associée à la position ( $x_x$ ) déterminées en dernier et, si la position ( $x_x$ ) déterminée en dernier et la position ( $x_2*$ ) escomptée ne coïncident pas, à détecter une position ( x ) > et/ou une vitesse ( v ) déterminée de manière erronée.

FIG 1

## FIG 2

## FIG 3

FIG 4

EP 2 116 814 B1

FIG 5

EP 2 116 814 B1

FIG 6

**IN DER BESCHREIBUNG AUFGEFÜHRTE DOKUMENTE**

**In der Beschreibung aufgeführte Patentdokumente**

- DE 2729697 A1
- EP 0116636 B1
- EP 0530176 B1
- US 4654636 A1
- WO 8911080 A
- EP 1164358 A1
- US 5317614 A
- EP 0268558 A2
- US 6556153 B1
- WO 9325865 A
- US 5206586 A
- US 6178821 B1